# EUROPÄISCHE PATENTSCHRIFT

(11) **EP 0 990 236 B1**
(45) Veröffentlichungstag und Bekanntmachung des Hinweises auf die Patenterteilung: **17.10.2001**
(21) Anmeldenummer: 98934815.6
(22) Anmeldetag: 27.05.1998
(51) Int. Cl.: G11C 29/00

(54) **ANORDNUNG MIT SPEICHERZELLEN UND VERFAHREN ZUR FUNKTIONSÜBERPRÜFUNG VON SPEICHERZELLEN**
STORAGE CELL SYSTEM AND METHOD FOR TESTING THE FUNCTION OF STORAGE CELLS
DISPOSITIF DOTE DE CELLULES MEMOIRE ET PROCEDE DE CONTROLE DU BON FONCTIONNEMENT DES CELLULES MEMOIRE

(30) Priorität: 17.06.1997 DE 19725581
(43) Veröffentlichungstag der Anmeldung: 05.04.2000
(73) Patentinhaber: Infineon Technologies AG, 81669 München (DE)
(72) Erfinder: RICHTER, Detlev, D-81827 München (DE); MCCONNELL, Roderick, D-81539 München (DE)
(74) Vertreter: Kottmann, Heinz Dieter, Dipl.-Ing.
(86) Internationale Anmeldenummer: DE9801457
(87) Internationale Veröffentlichungsnummer: WO9858386

(56) Entgegenhaltungen:
- JP-A- 8 313 591
- US-A- 5 073 891
- US-A- 5 617 531

## Beschreibung

Die Erfindung betrifft eine Anordnung mit Speicherzellen und ein Verfahren zur Funktionsüberprüfung von Speicherzellen.

Integrierte Speicher weisen Speicherzellen auf, in denen Daten gespeichert werden können. Üblicherweise handelt es sich dabei um digitale Daten, also um die logischen Zustände "0" und "1". Insbesondere im Anschluß an die Herstellung eines Speichers ist es erforderlich, die Funktionsfähigkeit des Speichers und damit seiner einzelnen Speicherzellen zu überprüfen. Hierzu ist es üblich, Testdaten in jede einzelne Speicherzelle einzuschreiben und wieder auszulesen, wobei anschließend ein Vergleich zwischen den eingeschriebenen und wieder ausgelesenen Daten erfolgt, so daß feststellbar ist, ob eine Funktionsstörung vorliegt oder nicht.

Eine einfache Funktionsüberprüfung ist auf folgende Weise durchführbar: Zunächst werden in sämtliche Speicherzellen des Speichers Nullen eingeschrieben und anschließend ausgelesen. Durch Vergleich der jeweils ausgelesenen Daten mit dem eingeschriebenen Datum "Null" werden Funktionsfehler erkannt. Anschließend wird analog in alle Speicherzellen eine Eins eingeschrieben, wieder ausgelesen und es findet wiederum jeweils der bereits beschriebene Vergleich, nun allerdings mit dem Datum "Eins", statt. Weist eine Speicherzelle in wenigstens einem der beiden geschilderten Fälle einen Funktionsfehler auf, gilt sie als defekt.

Außer dem geschilderten einfachen Fall, daß nacheinander lauter Nullen und lauter Einsen in die Speicherzellen eingeschrieben und wieder ausgelesen werden, sind natürlich auch kompliziertere Testmuster in den Speicher einschreibbar.

Um die Ausbeute bei Speichern zu erhöhen, ist es bekannt, redundante Zeilen bzw. redundante Spalten mit Speicherzellen vorzusehen, die aufgrund der gewonnenen Testergebnisse zum Ersetzen von Zeilen bzw. Spalten mit defekten Speicherzellen eingesetzt werden können. Zu ihrer Aktivierung erfolgt eine Programmierung (beispielsweise über Laserfuses), die zur Folge hat, daß bei Anliegen der entsprechenden Zeilen- bzw. Spaltenadresse statt der Zeile bzw. Spalte mit den defekten Speicherzellen eine der redundanten Zeilen bzw. Spalten adressiert wird.

Die beschriebene Funktionsüberprüfung erfordert die Übertragung großer Datenmengen - nämlich der aus den Speicherzellen wieder ausgelesenen Daten - vom zu überprüfenden Speicher zu einer entsprechenden Testeinrichtung, die die Überprüfung, einschließlich des Vergleichs zwischen den Testdaten und den wieder ausgelesenen Daten, vornimmt. Die mögliche Datenrate ist unter anderem durch die Anzahl der zur Verfügung stehenden Anschlüsse des Speichers limitiert. Insbesondere, wenn es sich bei dem Speicher um einen Speicherkern handelt, der sich als sogenanntes "Embedded Memory" gemeinsam mit weiteren Schaltungskomponenten, wie beispielsweise einem Prozessor, auf einer gemeinsamen integrierten Schaltung befindet, weist diese nur eine geringe Anzahl von externen Anschlüssen (im Extremfall sogar überhaupt keinen) auf, über die von außerhalb direkt auf den Speicher zugegriffen werden kann.

Um den Engpaß der wenigen zur Verfügung stehenden Anschlüsse zu umgehen, ist es bekannt, bei Embedded Memories eine die Funktionsüberprüfung durchführende Prüfschaltung auf derselben integrierten Schaltung vorzusehen, auf der sich der Speicher befindet. Sie kann als fest verdrahtete Logik oder als Controller realisiert sein und führt selbsttätig die gewünschte Funktionsüberprüfung (d.h. Einschreiben der Testdaten in die Speicherzellen, Auslesen der Speicherzellen und Vergleich der ausgelesenen Daten mit den Testdaten) durch, wobei bei Auftreten von Funktionsfehlern ein entsprechendes Ergebnissignal nach außerhalb der integrierten Schaltung geliefert wird. Allerdings kann auf diese Weise von außerhalb der integrierten Schaltung die Adresse der defekten Speicherzellen nicht festgestellt werden. Eine solche Realisierung wird auch als "Built-in Self Test" (BIST) bezeichnet.

Zur Durchführung der beschriebenen Funktionsüberprüfung weist die Prüfschaltung in der Regel entsprechende Speichermittel auf, in denen die Prüfergebnisse gespeichert werden können.

Die US-A 5,073,891 beschreibt ein Verfahren und eine Vorrichtung zur Funktionsüberprüfung von Speicherzellen, bei der der Speicher in zwei Gruppen ("Partitions") geteilt wird, die nacheinander geprüft werden, während die jeweils andere Gruppe für andere Zwecke gebraucht wird.

Die US-A 4,654,847 beschreibt eine Vorrichtung zur automatischen Korrektur von fehlerbehafteten Daten. In einem Hauptspeicher werden Datenfehler detektiert. Handelt es sich um Einzel-Bit-Fehler, werden diese beim Auslesen durch eine Fehlerkorrektureinheit behoben. Treten Mehr-Bit-Fehler auf, wird die Adressse, die Position und der richtige Wert des jeweiligen Datums in einem zusätzlichen Speicher abgelegt, der kleiner als der Hauptspeicher ist

Der Erfindung liegt die Aufgabe zugrunde, die Funktionsüberprüfung von Speicherzellen zu erleichtern.

Diese Aufgabe wird mit einem Verfahren gemäß Anspruch 1 sowie einer Anordnung gemäß Anspruch 7 gelöst. Vorteilhafte Weiterbildungen und Ausgestaltungen der Erfindung sind in abhängigen Ansprüchen gekennzeichnet.

Das erfindungsgemäße Verfahren sieht vor, zunächst nur eine erste Gruppe der Speicherzellen zu prüfen und die dabei anfallenden Prüfergebnisse in einer zweiten Gruppe der Speicherzellen zwischenzuspeichern. Dabei werden die Prüfergebnisse vorübergehend in den ebenfalls zu prüfenden Speicherzellen der zweiten Gruppe gespeichert, ohne daß hierfür ein zusätzlicher Speicher als Bestandteil des die Prüfung durchführenden Prüfmittels notwendig ist. Somit reduziert sich vorteilhaft der Aufwand für die Realisierung des Prüfmittels.

Eine besonders vorteilhafte Weiterbildung der Erfindung sieht vor, daß die Speicherzellen der beiden Gruppen Bestandteile eines gemeinsamen Speichers sind und daß das vor einer Ausgabe der Prüfergebnisse aus dem Speicher das Zwischenspeichern in den Speicherzellen der zweiten Gruppe erfolgt. Da die Speicherzellen der ersten Gruppe getestet werden, bevor Prüfergebnisse nach außerhalb des Speichers ausgegeben werden, ist der Zeitpunkt der Ausgabe der Prüfergebnisse vorteilhafterweise unabhängig von ihrer Erzeugung. Damit kann die Funktionsüberprüfung schneller durchgeführt werden, da sie vom Engpaß der Übertragung der Prüfungsergebnisse über die externen Anschlüsse nach außerhalb entkoppelt ist.

Vorteilhaft ist weiterhin, daß durch das Speichern der Prüfergebnisse in der Speicheranordnung eine Nachbereitung der zwischengespeicherten Prüfergebnisse möglich ist, bevor sie nach außerhalb des Speichers ausgelesen werden. Hierdurch kann eine Komprimierung der Prüfergebnisse erzielt werden, beispielsweise indem nur die Adressen defekter der Speicherzellen nach außerhalb der Speicheranordnung ausgegeben werden.

Nach einer Weiterbildung der Erfindung wird anhand der gespeicherten Prüfergebnisse eine Redundanzanalyse der geprüften Speicherzellen durchgeführt, woraufhin nur die Ergebnisse der Redundanzanalyse, nämlich die Adressen von durch redundante Zeilen bzw. redundante Spalten zu ersetzenden Zeilen bzw. Spalten der Speicherzellen nach außerhalb der Speicheranordnung übermittelt werden. Dies hat den Vorteil, daß durch die on-chip durchgeführte Redundanzanalyse ebenfalls eine Komprimierung der Prüfergebnisse erfolgt, die anschließend nicht komplett, sondern nur reduziert auf das Ergebnis der Redundanzanalyse nach außerhalb der Speicheranordnung gegeben werden. Somit ist die zu übertragende Datenmenge wesentlich reduziert. Das nach außerhalb übertragene Ergebnis der Redundanzanalyse kann direkt für eine entsprechende Programmierung der redundanten Zeilen bzw. Spalten der Speicheranordnung (z.B. durch Aufschmelzen von trennbaren Verbindungen mittels Laser) durch eine entsprechende externe Programmierschaltung verwendet werden.

Nach einer Weiterbildung der Erfindung werden die gespeicherten Prüfergebnisse aus den Speicherzellen der zweiten Gruppe ausgelesen und anschließend die Speicherzellen der zweiten Gruppe geprüft, wobei die entsprechenden Prüfergebnisse in den Speicherzellen der ersten Gruppe zwischengespeichert werden. Auf diese Weise ist es möglich, alle Speicherzellen der Speicheranordnung in zwei aufeinanderfolgenden Phasen zu überprüfen. Selbstverständlich ist es auch möglich, die Speicheranordnung in mehr als zwei Gruppen von Speicherzellen aufzuteilen, die erfindungsgemäß wechselweise geprüft werden.

Eine Weiterbildung der Erfindung sieht vor, daß die Prüfergebnisse unter Verwendung eines Fehlerkorrekturcodes in den Speicherzellen der ersten bzw. zweiten Gruppe gespeichert werden. Dies ermöglicht beim Auslesen bzw. Auswerten der Prüfergebnisse aus den Speicherzellen (beispielsweise bei der beschriebenen Redundanzanalyse) die Korrektur von Fehlern, die beim Speichern der Prüfergebnisse auftreten. Solche Fehler sind beispielsweise darauf zurückzuführen, daß die Speicherzellen der zweiten Gruppe beim Zwischenspeichern der Prüfergebnisse der Speicherzellen der ersten Gruppe noch keiner Funktionsüberprüfung unterzogen worden sind.

Alternativ oder ergänzend zur Verwendung von Fehlerkorrekturcodes beim Speichern der Prüfergebnisse ist es nach einer Weiterbildung der Erfindung vorgesehen, die Prüfergebnisse jeweils wenigstens zweifach in den Speicherzellen der ersten bzw. der zweiten Gruppe zu speichern und beim Auslesen der Prüfergebnisse einen Vergleich zwischen den Kopien jedes der Prüfergebnisse vorzunehmen. Auf diese Weise ist ebenfalls feststellbar, ob beim Speichern der Prüfergebnisse Fehler aufgetreten sind. Werden mehr als zwei Kopien jedes Prüfergebnisses gespeichert, ist auch eine Fehlerkorrektur dadurch möglich, daß derjenige Wert, der beim Auslesen aus den Speicherzellen innerhalb der Kopien eines Prüfergebnisses am häufigsten vorkommt, als "richtiges" Prüfergebnis angesehen wird.

Eine Weiterbildung der Erfindung sieht vor, daß als Prüfergebnisse nur Adressen von defekten Speicherzellen gespeichert werden. Anstelle des Erstellens einer sogenannten "Bit-Map", bei der jeder Speicherzelle ein entsprechendes Ergebnisbit zugeordnet wird, das als binäre Information das Prüfergebnis "funktionsfähig" bzw. "defekt" enthält, läßt sich auf diese Weise die Menge der als Prüfergebnis zu speichernden Daten reduzieren, da im allgemeinen ein nur sehr geringer Anteil der gesamten Speicherzellen defekt ist.

Die erfindungsgemäße Anordnung weist Speicherzellen und ein Prüfmittel zu deren Funktionsüberprüfung gemäß dem geschilderten erfindungsgemäßen Verfahren auf.

Eine Ausführungsform der Erfindung sieht vor, daß die erste und die zweite Gruppe von Speicherzellen Bestandteile verschiedener Speicher sind. Diese können beispielsweise auf unterschiedlichen integrierten Schaltungen angeordnet sein. Es werden dann beide Speicher abwechselnd getestet, wobei in einem der beiden die Prüfergebnisse des jeweils anderen zwischengespeichert werden. Die Erfindung ist auch zur Funktionsüberprüfung von auf einem Wafer angeordneten Gruppen von Speicherzellen anwendbar.

Die Erfindung wird im folgenden anhand der Figuren näher erläutert. Die Ausführungsbeispiele der Erfindung zeigen:
- Figur 1: ein erstes Ausführungsbeispiel einer erfindungsgemäßen Anordnung,
- Figur 2: ein Detail aus Figur 1,
- Figur 3: ein Detail eines zweiten Ausführungsbeispiels der erfindungsgemäßen Anordnung,
- Figur 4: ein Ausführungsbeispiel eines Details aus Figur 3, nämlich eine zweite Gruppe von Speicherzellen, in denen Prüfergebnisse in Form einer Bit-Fail-Map gespeichert sind,
- Figur 5: ein anderes Ausführungsbeispiel eines Details aus Figur 3, nämlich eine zweite Gruppe von Speicherzellen, in denen Prüfergebnisse in komprimierter Form gespeichert sind,
- Figur 6: ein weiteres Ausführungsbeispiel der Erfindung mit zwei zu prüfenden Speichern und

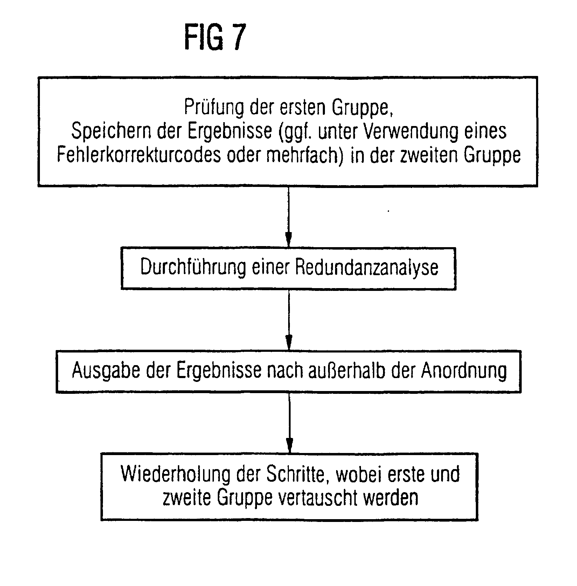

- Figur 7: ein Ausführungsbeispiel des erfindungsgemäßen Prüfungsverfahrens.

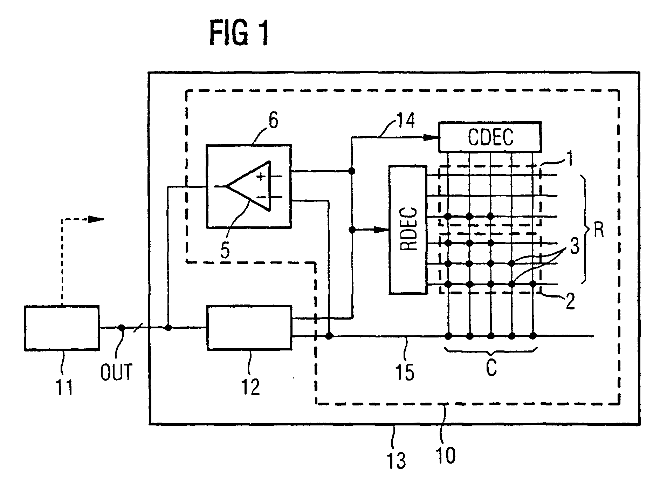

Figur 1 zeigt ein erstes Ausführungsbeispiel der Erfindung. Dargestellt ist ein auf einer integrierten Schaltung 13 angeordneter Speicher 10, der Speicherzellen 3 und ein Prüfmittel 6 zur Überprüfung der Funktionsfähigkeit der Speicherzellen 3 aufweist. Die Speicherzellen 3 sind matrixförmig in Zeilen R und Spalten C angeordnet. Die Zeilen R sind über einen Zeilendecoder RDEC und die Spalten C über einen Spaltendecoder CDEC adressierbar. Die Speicherzellen 3 sind DRAM-Speicherzellen, die für gewöhnlich als 1-Transistor-1-Kondensator-Speicherzellen realisiert sind. Es kommen auch andere Arten von Speicherzellen in Frage.

Die eine Hälfte der Speicherzellen 3 sind zu einer ersten Gruppe 1 zusammengefaßt und die andere Hälfte der Speicherzellen 3 zu einer zweiten Gruppe 2.

In den Figuren sind nur für die Erfindung wesentliche Komponenten dargestellt. Daher ist auch nur eine geringe Anzahl der Speicherzellen 3 dargestellt.

Die integrierte Schaltung 13 weist weiterhin einen Mikrocontroller 12 auf, der über einen Adreßbus 14 mit den Decodern RDEC, CDEC verbunden ist. Vom Microcontroller 12 über den Adreßbus 14 adressierte Speicherzellen 3 sind über einen Datenbus 15 vom Controller 12 beschreibbar oder können durch diesen ausgelesen werden. Beim dargestellten Speicher 10 handelt es sich um ein Embedded Memory, auf welches ausschließlich über den Controller 12 zugreifbar ist, nicht jedoch direkt von außerhalb der integrierten Schaltung 13. Der Controller 12 ist mit externen Anschlüssen OUT der integrierten Schaltung 13 verbunden, über die er mit ihrer Umgebung kommuniziert.

Das Prüfmittel 6 ist ebenfalls mit dem Adreßbus 14 und dem Datenbus 15 verbunden, so daß es über den Adreßbus 14 die Speicherzellen 3 adressieren kann und über den Datenbus 15 Daten in diese einschreiben beziehungsweise aus ihnen wieder auslesen kann. Für die Durchführung einer Funktionsüberprüfung der Speicherzellen 3 schreibt das Prüfmittel 6 Testdaten (beispielsweise lauter Einsen oder lauter Nullen) in alle Speicherzellen 3 der ersten Gruppe 1. Anschließend liest das Prüfmittel 6 die Speicherzellen 3 der ersten Gruppe 1 wieder nacheinander aus und vergleicht die ausgelesenen Daten mit dem zuvor eingeschriebenen Testdatum. In Figur 1 ist angedeutet, daß dieser Vergleich zwischen Soll- und Istwert mittels eines Komparators 5 durchgeführt wird. Das Ergebnis dieses Vergleichs, also das Ausgangssignal des Komparators 5, wird für jede Speicherzelle 3 der ersten Gruppe 1 in je einer Speicherzelle 3 der zweiten Gruppe 2 abgespeichert, die bei diesem Ausführungsbeispiel dieselbe Anzahl von Speicherzellen 3 aufweist, wie die erste Gruppe 1.

Erfindungsgemäß ist weiterhin vorgesehen, daß nach der Überprüfung der Speicherzellen 3 der ersten Gruppe 1 die in den Speicherzellen 3 der zweiten Gruppe 2 gespeicherten Prüfergebnisse vom Prüfmittel 6 ausgelesen und über die externen Anschlüsse OUT der integrierten Schaltung 13 nach außerhalb derselben gegeben werden. Außerhalb der integrierten Schaltung 13 werden die Prüfergebnisse mittels einer Prüfschaltung 11 weiter ausgewertet, um abschließend festzustellen, ob der Speicher 10 die Funktionsüberprüfung bestanden hat oder nicht.

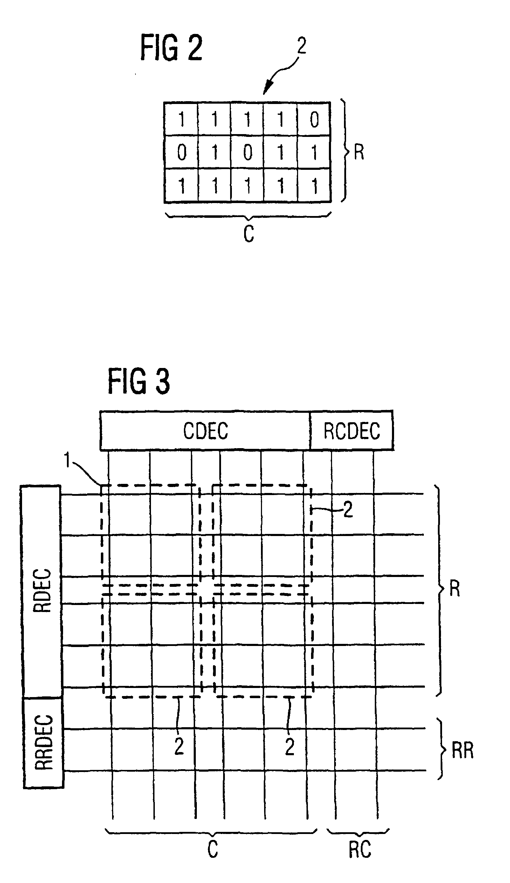

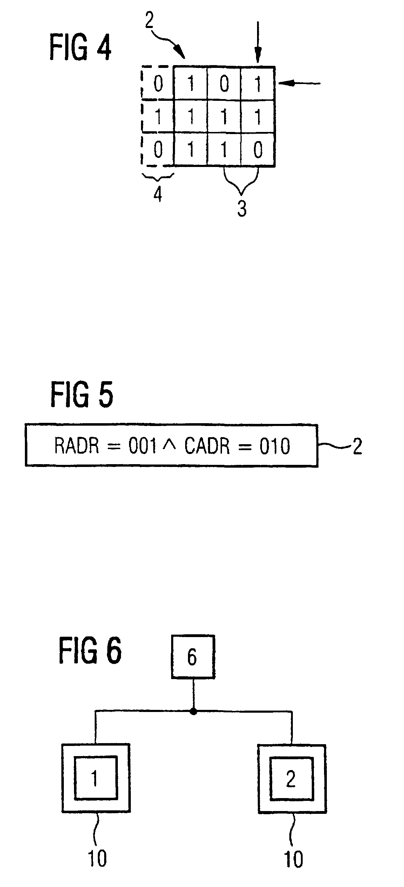

Figur 2 zeigt die Speicherzellen 3 der zweiten Gruppe 2 aus Figur 1, in die bereits die Prüfergebnisse durch das Prüfmittel 6 eingetragen wurden. Eine Eins gibt dabei eine Übereinstimmung von Soll- und Istwert an, während eine gespeicherte Null anzeigt, daß Soll- und Istwert verschieden sind, das heißt, daß die entsprechende Speicherzelle 3 der ersten Gruppe 1 defekt ist. Da jeder Speicherzelle 3 der ersten Gruppe 1 eine Speicherzelle 3 der zweiten Gruppe 2 (in Figur 4 sind dies diejenigen mit durchgezogenen Linien) zugeordnet sind, ist auf diese Weise eine sogenannte Bit-Fail-Map erstellt worden, der die Lage der defekten und der intakten Speicherzellen 3 innerhalb der ersten Gruppe 1 entnehmbar ist.

Bei diesem Ausführungsbeispiel werden nur die Adressen der defekten Speicherzellen 3 aus der ersten Gruppe nach außerhalb der integrierten Schaltung 13 zur Prüfschaltung 11 übermittelt. Hierdurch kann eine bedeutende Reduzierung der zu übertragenden Datenmenge erreicht werden.

Figur 5 zeigt ein anderes Ausführungsbeispiel der Erfindung, bei dem innerhalb der zweiten Gruppe 2 keine Bit-Fail-Map wie in Figur 3 gespeichert ist, sondern lediglich die in Spaltenadressen CADR und Reihenadressen RADR unterteilten Adressen der einzelnen defekten Speicherzellen. Da in der Regel viel weniger Speicherzellen defekt als intakt sind, läßt sich auf diese Weise eine Komprimierung der zu speichernden Prüfergebnisse erreichen, so daß in diesem Fall die Anzahl der Speicherzellen 3 der zweiten Gruppe 2 sehr viel geringer gewählt werden kann, als die Anzahl der Speicherzellen 3 der ersten Gruppe 1. Auch hier reduziert sich die zur Prüfschaltung 11 zu übermittelnde Datenmenge bei Ausgabe der Prüfergebnisse.

Figur 3 zeigt ein zweites Ausführungsbeispiel der Speichermatrix des Speichers 10, der im Unterschied zu derjenigen aus Figur 1 zusätzlich Zeilen RR und Spalten RC mit redundanten Speicherzellen aufweist. Die redundanten Zeilen RR und Spalten RC dienen im Redundanzfall einem adressenmäßigen Ersetzen je einer der Reihen R beziehungsweise Spalten C der Speicherzellen 3. Das Prüfmittel 6 führt nun eine Funktionsüberprüfung der Speicherzellen 3 der ersten Gruppe 1 durch und speichert die Prüfergebnisse, wie zuvor anhand der Figur 3 erläutert, in den Speicherzellen 3 der zweiten Gruppe 2. Zusätzlich führt das Prüfmittel 6 dieses Ausführungsbeispiels eine Redundanzanalyse der in den Speicherzellen 3 der zweiten Gruppe 2 gespeicherten Prüfergebnisse durch. Bei einer Redundanzanalyse wird festgestellt, welche Zeilen beziehungsweise Spalten von Speicherzellen durch eine der redundanten Spalten beziehungsweise Zeilen zu ersetzen ist, da sie wenigstens eine Speicherzelle aufweist, die defekt ist. In Figur 4 wurde je eine Zeile und je eine Spalte durch Pfeile markiert, deren zugehörige Zeilen und Spalten in der ersten Gruppe 1 aufgrund der durch die Nullen gekennzeichneten Defekte durch eine redundante Spalte beziehungsweise Zeile zu ersetzen sind. Algorithmen zur Durchführung der beschriebenen Redundanzanalyse sind dem Fachmann von herkömmlichen Redundanzanalyseschaltungen, die üblicherweise bei Speichertestern für DRAMs eingesetzt werden, bekannt.

Die in Figur 1 dargestellte Prüfschaltung 11 erhält die Ergebnisse der Redundanzanalyse und führt eine (durch den gestrichelten Pfeil angedeutete) entsprechende Programmierung von (nicht dargestellten) Fuseelementen in Redundanzdecodern RRDEC, RCDEC zur Adressierung der redundanten Leitungen RR, RC und in den Normaldecodern RDEC, CDEC durch.

In Figur 4, die in der zweiten Gruppe gespeicherte Prüfergebnisse der ersten Gruppe enthält, sind je eine zu ersetzende Zeile R und Spalte C mit defekten Speicherzellen 3 (gekennzeichnet durch die zwischengespeicherte Null) durch Pfeile markiert.

Figur 4 ist noch ein anderes Merkmal eines weiteren Ausführungsbeispiels der zweiten Gruppe 2 von Speicherzellen 3 zu entnehmen, bei denen ein Teil der Speicherzellen 3 (in Figur 4 gestrichelt dargestellt) zum Speichern von Paritätsbits 4 dient. Der Einfachheit halber ist nur ein Paritätbit pro Zeile R dargestellt. Die Paritätsbits 4 werden ebenfalls durch das Prüfmittel 6 in der zweiten Gruppe 2 gespeichert, und zwar während des Speicherns der Prüfergebnisse in den übrigen Speicherzellen 3 der zweiten Gruppe 2. Dabei werden die Paritätsbits 4 mittels eines Fehlerkorrekturcodes erzeugt, wie beispielsweise dem Reed-Solomon-Code. Der Einsatz eines solchen Fehlerkorrekturcodes ermöglicht beim späteren Auslesen der Prüfergebnisse durch das Prüfmittel 6 das Erkennen und gegebenenfalls die Korrektur von beim Zwischenspeichern möglicherweise verfälschten Prüfergebnissen.

Das Ausführungsbeispiel in Figur 3 unterscheidet sich von demjenigen in Figur 1 auch darin, daß bei ihm drei zweite Gruppen 2 mit Speicherzellen 3 innerhalb des Speichers 10 vorhanden sind, die alle dieselbe Anzahl von Speicherzellen 3 aufweisen, wie die erste Gruppe 1. Das Prüfmittel 6 speichert jedes Prüfergebnis in jeder der zweiten Gruppe 2, so daß alle Prüfergebnisse dreifach vorliegen. Beim Ausgeben der Prüfergebnisse oder beim Auswerten der Prüfergebnisse im Zuge einer Redundanzanalyse führt das Prüfmittel 6 einen Vergleich aller drei Kopien jedes der Prüfergebnisse durch, so daß es beim Speichern der Prüfergebnisse auftretende Fehler erkennt und denjenigen Wert des Prüfergebnisses, welcher am häufigsten innerhalb der Kopien des jeweiligen Prüfergebnisses auftaucht, als korrektes Prüfergebnis weiterverarbeitet.

Figur 6 zeigt ein Ausführungsbeispiel der Erfindung, bei dem die erste Gruppe 1 von Speicherzellen 3 und die zweite Gruppe 2 von Speicherzellen 3 in unterschiedlichen Speichern 10 angeordnet sind. Auch hier ist die Erfindung anwendbar, so daß das die Prüfung durchführende Prüfmittel 6 keinen zusätzlichen Speicher zum Speichern der Prüfergebnisse benötigt.

Das Prüfmittel 6 kann entweder durch einen Microcontroller realisiert sein, der zur Durchführung der beschriebenen Funktionsüberprüfung ein entsprechendes Testprogramm abarbeitet, oder es kann durch eine festverdrahtete Logik realisiert sein. Der Einsatz dieser beiden Varianten zur Durchführung einer Funktionsüberprüfung bei Speichern sind dem Fachmann von der Realisierung von Build-In-Self-Tests bekannt.

## Patentansprüche

1. Verfahren zur Funktionsüberprüfung von Speicherzellen (3),
- bei dem eine erste Gruppe (1) der Speicherzellen (3) geprüft wird, wobei entsprechende Prüfergebnisse in einer zweiten Gruppe (2) der Speicherzellen (3) gespeichert werden,
- und bei dem die in den Speicherzellen (3) der zweiten Gruppe (2) gespeicherten Prüfergebnisse ausgegeben werden,
**dadurch gekennzeichnet,**
**daß** anschließend die Speicherzellen (3) der zweiten Gruppe (2) geprüft werden, wobei entsprechende Prüfergebnisse in den Speicherzellen (3) der ersten Gruppe (1) gespeichert werden.

2. Verfahren nach Anspruch 1,
bei dem die Prüfergebnisse unter Verwendung eines Fehlerkorrekturcodes (4) in den Speicherzellen (3) der ersten (1) und/oder zweiten (2) Gruppe gespeichert werden.

3. Verfahren nach Anspruch 1,
bei dem die Prüfergebnisse wenigstens in doppelter Ausführung in den Speicherzellen (3) der ersten (1) und/oder zweiten (2) Gruppe gespeichert werden und anschließend ein Vergleich (5) zwischen den Kopien jedes der Prüfergebnisse erfolgt.

4. Verfahren nach einem der Ansprüch 1 bis 3,
**dadurch gekennzeichnet,**
**dass** die Prüfergebnisse unter Hinzufügung einer Zusatzinformation in der zweiten Gruppe (2) von Speicherzellen (3) gespeichert werden, wobei die Zusatzinformation während einer nachfolgenden Auswertung der Prüfergebnisse dem Erkennen eines beim Speichern der Prüfergebnisse in der zweiten Gruppe (2) gegebenenfalls auftretenden Fehlers dient.

5. Verfahren nach Anspruch 4,
wobei die Prüfergebnisse unter Verwendung eines Fehlerkorrekturcodes (4) in der zweiten Gruppe (2) von Speicherzellen (3) gespeichert werden.

6. Verfahren nach Anspruch 4,
- bei dem die Prüfergebnisse wenigstens in doppelter Ausführung in der zweiten Gruppe (2) von Speicherzellen (3) gespeichert werden,
- und bei dem anschließend ein Vergleich (5) zwischen den Kopien jedes der Prüfergebnisse erfolgt.

7. Anordnung
- mit einer ersten Gruppe (1) und einer zweiten Gruppe (2) von Speicherzellen (3)
- und mit einem Prüfmittel (6) zur Funktionsüberprüfung der Speicherzellen (3),
-- das die Speicherzellen (3) der ersten Gruppe (1) prüft, wobei es entsprechende Prüfergebnisse in den Speicherzellen (3) der zweiten Gruppe (2) speichert,
-- und das die Prüfergebnisse aus den Speicherzellen (3) der zweiten Gruppe (2) nach außerhalb der Anordnung ausgibt.
**dadurch gekennzeichnet,**
**daß** das Prüfmittel (6) die Speicherzellen (3) der zweiten Gruppe (2) prüft, wobei es entsprechende Prüfergebnisse in den Speicherzellen (3) der ersten Gruppe (1) speichert.

8. Anordnung nach Anspruch 7,
deren Prüfmittel (6) die Prüfergebnisse unter Verwendung eines Fehlerkorrekturcodes in den Speicherzellen (3) der zweiten Gruppe (2) speichert.

9. Anordnung nach Anspruch 7,
deren Prüfmittel (6) die Prüfergebnisse wenigstens in doppelter Ausführung in den Speicherzellen (3) der ersten (1) und/oder zweiten (2) Gruppe speichert und anschließend einen Vergleich (5) zwischen den Kopien jedes der Prüfergebnisse durchführt.

## Claims

1. Method of checking the operation of memory cells (3)
- in which a first group (1) of the memory cells (3) is tested, with corresponding test results being stored in a second group (2) of the memory cells (3),
- and in which the test results stored in the memory cells (3) in the second group (2) are output,
**characterized in that** the memory cells (3) in the second group (2) are then tested, with corresponding test results being stored in the memory cells (3) in the first group (1).

2. Method according to Claim 1, in which the test results are stored in the memory cells (3) in the first (1) and/or in the second (2) group using an error correction code (4).

3. Method according to Claim 1, in which the test results are stored in the memory cells (3) in the first (1) and/or in the second (2) group at least in duplicate, and the copies of each of the test results are then compared (5).

4. Method according to one of Claims 1 to 3,
**characterized in that** the test results are stored in the second group (2) of memory cells (3) with the addition of supplementary information, the supplementary information being used, during subsequent evaluation of the test results, to recognize any error which might occur when the test results are stored in the second group (2).

5. Method according to Claim 4, in which the test results are stored in the second group (2) of memory cells (3) using an error correction code (4).

6. Method according to Claim 4,
- in which the test results are stored in the second group (2) of memory cells (3) at least in duplicate,
- and in which the copies of each of the test results are then compared (5).

7. Arrangement
- having a first group (1) and a second group (2) of memory cells (3),
- and having a test means (6) for checking the operation of the memory cells (3),
-- said test means testing the memory cells (3) in the first group (1) and storing corresponding test results in the memory cells (3) in the second group (2),
-- and said test means outputting the test results from the memory cells (3) in the second group (2) to outside the arrangement,
**characterized in that** the test means (6) tests the memory cells (3) in the second group (2) and stores corresponding test results in the memory cells (3) in the first group (1).

8. Arrangement according to Claim 7, whose test means (6) stores the test results in the memory cells (3) in the second group (2) using an error correction code.

9. Arrangement according to Claim 7, whose test means (6) stores the test results in the memory cells (3) in the first (1) and/or in the second (2) group at least in duplicate and then compares (5) the copies of each of the test results.

## Revendications

1. Procédé de contrôle du fonctionnement de cellules (3) de mémoire,
- dans lequel on contrôle un premier groupe (1) des cellules (3) de mémoire, les résultats de contrôle correspondants étant mémorisés dans un deuxième groupe (2) des cellules (3) de mémoire
- et dans lequel les résultats de contrôle mémorisés dans les cellules (3) de mémoire du deuxième groupe (2) sont sortis,
**caractérisé**
**en ce que**, ensuite, les cellules (3) de mémoire du deuxième groupe (2) sont contrôlées, des résultats de contrôle correspondants étant mémorisés dans les cellules (3) de mémoire du premier groupe (1).

2. Procédé suivant la revendication 1, dans lequel les résultats de contrôle sont mémorisés dans les cellules (3) de mémoire du premier (1) et/ou du deuxième (2) groupe en utilisant un code (4) de correction d'erreurs.

3. Procédé suivant la revendication 1, dans lequel les résultats de contrôle sont mémorisés au moins en effectuant deux fois l'opération dans les cellules (3) de mémoire du premier (1) et/ou du deuxième (2) groupe et ensuite une comparaison (5) est effectuée entre les copies de chacun des résultats du contrôle.

4. Procédé suivant l'une des revendications 1 à 3, **caractérisé en ce que** les résultats de contrôle sont mémorisés avec addition d'une information supplémentaire dans le deuxième groupe (2) de cellules (3) de mémoire, l'information supplémentaire servant pendant une exploitation ultérieure des résultats du contrôle à reconnaître une erreur se produisant le cas échéant lors de la mémorisation des résultats de contrôle dans le deuxième groupe (2).

5. Procédé suivant la revendication 4, dans lequel les résultats de contrôle sont mémorisés dans le deuxième groupe (2) des cellules (3) de mémoire en utilisant un code (4) de correction d'erreurs.

6. Procédé suivant la revendication 4,
- dans lequel les résultats de contrôle sont mémorisés au moins en étant effectués en double dans le deuxième groupe (2) de cellules (3) de mémoire
- et dans lequel ensuite une comparaison (5) est effectuée entre les copies de chacun des résultats de contrôle.

7. Dispositif
- comprenant un premier groupe (1) et un deuxième groupe (2) de cellules (3) de mémoire
- et un moyen (6) de contrôle destiné à contrôler le fonctionnement des cellules (3) de mémoire,
- qui contrôle les cellules (3) de mémoire du premier groupe (1) des résultats correspondants de contrôle étant mémorisés dans les cellules (3) de mémoire du deuxième groupe (2),
- et qui sort à l'extérieur du dispositif des résultats de contrôle provenant des cellules (3) de mémoire du deuxième groupe (2)
**caractérisé en ce que** le moyen (6) de contrôle contrôle les cellules (3) de mémoire du deuxième groupe (2), des résultats correspondants de contrôle étant mémorisés dans les cellules (3) de mémoire du premier groupe (1).

8. Dispositif suivant la revendication 7, dont le moyen (6) de contrôle mémorise les résultats de contrôle dans les cellules (3) de mémoire du deuxième groupe (2) en utilisant un code de correction d'erreurs.

9. Dispositif suivant la revendication 7, dont le moyen (6) de contrôle mémorise les résultats de contrôle au moins suivant une exécution double dans les cellules (3) de mémoire du premier (1) et/ou du deuxième (2) groupe et ensuite effectue une comparaison (5) entre les copies de chacun des résultats de contrôle.
